(19) Europäisches Patentamt / European Patent Office / Office européen des brevets

(11) **EP 4 643 077 B1**

(12) **FASCICULE DE BREVET EUROPEEN**

(45) Date de publication et mention
de la délivrance du brevet:
**05.08.2026 Bulletin 2026/32**

(21) Numéro de dépôt: **23818520.1**

(22) Date de dépôt: **11.12.2023**

(51) Classification Internationale des Brevets (IPC):
**F28F 1/24** *(2006.01)* **F28F 13/12** *(2006.01)*

(52) Classification Coopérative des Brevets (CPC):
**F28F 1/24; F28F 13/12; H10W 40/226;**
F28F 2215/10; H10W 40/43

(86) Numéro de dépôt international:
**PCT/EP2023/085034**

(87) Numéro de publication internationale:
**WO 2024/141247 (04.07.2024 Gazette 2024/27)**

(54) **ARCHITECTURE D'AILETTE FAVORISANT LE BRASSAGE DU FLUIDE CALOPORTEUR**

RIPPENARCHITEKTUR ZUR FÖRDERUNG DES RÜHRENS EINER WÄRMEÜBERTRAGUNGSFLÜSSIGKEIT

FIN ARCHITECTURE FOR PROMOTING HEAT TRANSFER FLUID STIRRING

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **27.12.2022 FR 2214519**

(43) Date de publication de la demande:
**05.11.2025 Bulletin 2025/45**

(73) Titulaire: **THALES**
**92190 Meudon (FR)**

(72) Inventeur: **GRIMARDIAS, Ivan**
**06903 Sophia Antipolis Cedex (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
CN-A- 114 650 705     DE-U1- 202004 020 294
US-A1- 2009 321 046     US-A1- 2010 206 538
US-B1- 6 269 002

**Description**

L'invention concerne le refroidissement d'un élément produisant de la chaleur. L'invention trouve une application dans le domaine des machines électriques et de l'électronique de puissance. En effet, il est connu que les équipements électroniques, les calculateurs, et l'électronique de manière générale engendrent des pertes qui se traduisent par une production de chaleur qu'il est nécessaire d'évacuer. L'évacuation de cette chaleur, garantissant un bon fonctionnement des éléments cités précédemment, devient donc une priorité. L'invention trouve une application particulière dans le domaine de l'électronique embarquée où la tendance est d'augmenter le nombre d'équipements électriques et donc la puissance électrique embarquée. Spécifiquement, la présente invention se rapporte à un dispositif de refroidissement tel que défini par le préambule de la revendication 1, et tel qu'illustré par le document DE 20 2004 020 294U.

L'invention porte plus particulièrement sur une architecture d'ailette de refroidissement pour un tel échangeur thermique.

Actuellement, un grand nombre de systèmes électroniques sont équipés d'échangeur thermique, permettant d'évacuer la chaleur des éléments dissipant de l'énergie thermique vers une source d'évacuation de cette chaleur, afin de permettre à cette électronique de fonctionner dans des conditions optimales.

Il est aujourd'hui connu des échangeurs thermiques comprenant un ensemble d'ailettes disposées dans une axe de déplacement d'un flux caloporteur pour lequel l'échange thermique avec un second fluide ou l'élément thermique même est souhaité, par exemple des ailettes droites dans le sens d'un flux d'air traversant l'échangeur thermique se servant des ailettes pour extraire l'énergie thermique vers un fluide à température inférieure, ou un fluide utilisant les ailettes pour extraire l'énergie thermique générée par un composant électronique.

La fonction des ailettes est de permettre l'échange thermique entre deux fluides, ou un fluide et un élément solide conducteur de chaleur, ces deux éléments étant à des températures différentes. Plus précisément, les ailettes sont alors des interfaces servant à améliorer l'efficacité d'échanges entre les éléments cités, à savoir les deux fluides caloporteurs ou le fluide et l'élément solide.

L'utilisation d'un unique flux caloporteur balayant l'échangeur thermique est toutefois privilégié pour des raisons de compacité et de poids. En effet, l'ajout d'un second fluide caloporteur et de l'ensemble du circuit permettant la circulation de ce second fluide génère souvent un excédent de masse et de volume qu'il devient nécessaire de prendre en considération, surtout dans le domaine de l'aéronautique dans lequel la problématique principale est la gestion de la masse du véhicule.

Par conséquent, le refroidissement d'une machine électrique est aujourd'hui limité par des contraintes de masse et d'encombrement que l'état de l'art n'est pas capable de surmonter.

Ainsi, dans une configuration de refroidissement entre un fluide caloporteur opérant une extraction directe de la chaleur des ailettes de l'échangeur thermique, une surface d'échange en contact avec l'échangeur thermique et avec le fluide caloporteur, au niveau des ailettes de refroidissement, peut être identifiée pour permettre cette extraction thermique.

Cependant, cette extraction directe de la chaleur est fonction de la différence de température entre la température de la surface d'échange thermique de l'échangeur thermique, ou globalement de l'ailette de refroidissement, et la température du fluide caloporteur balayant cette surface d'échange thermique et le dispositif de refroidissement. En effet, plus la différence de température est élevée entre la surface d'échange thermique et le fluide caloporteur, plus l'échange thermique est important. Ainsi, une surface d'échange thermique de température élevée par rapport à la température du fluide caloporteur, ou, à l'inverse, une température de fluide caloporteur faible par rapport à la température de la surface d'échange thermique permet d'améliorer grandement l'échange thermique.

Or, la température du fluide caloporteur varie lorsque le fluide caloporteur balaye la surface d'échange thermique et les ailettes de refroidissement du dispositif de refroidissement. En effet, l'échange thermique qui s'opère entre la surface d'échange thermique et le fluide caloporteur provoque une augmentation de la température du fluide caloporteur qui échange thermiquement le long de la surface d'échange du dispositif de refroidissement. Cette augmentation de la température du fluide caloporteur et donc cette diminution de la différence de température entre le corps chaud, à savoir la surface d'échange thermique, et le corps froid, à savoir le fluide caloporteur, dégrade l'extraction thermique entre ces deux corps.

L'invention vise à pallier tout ou partie des problèmes cités plus haut en proposant une architecture d'ailette de refroidissement permettant d'une part un brassage du fluide caloporteur balayant l'ailette permettant d'homogénéiser la température du fluide caloporteur échangeant thermiquement avec la surface d'échange thermique et, d'autre part, d'évacuer le fluide caloporteur à forte température et le remplacer par du fluide caloporteur de température plus faible, améliorant ainsi l'extraction de chaleur.

L'invention permet avantageusement d'augmenter la durée d'échange entre un corps chaud et le flux caloporteur en allongeant la distance parcourue par le fluide caloporteur le long du corps chaud.

A cet effet, l'invention a pour objet un dispositif de refroidissement présentant une surface d'échange thermique configuré pour permettre un échange thermique avec un fluide caloporteur le long de la surface d'échange thermique selon une première direction, l'échange thermique s'opérant par convection entre la surface d'échange thermique et le fluide caloporteur, le dispositif de refroidissement comprenant au moins une ailette de refroidissement, la surface d'échange thermique étant configurée pour recevoir par conduction de la chaleur destinée à être évacuée par l'ailette de refroidissement, l'ailette de refroidissement comprenant au moins un guide de brassage de fluide fixe et à distance par rapport à la surface d'échange thermique, l'au moins un guide de brassage de fluide présentant une surface gauche, l'au moins un guide de brassage du fluide étant disposé de sorte à générer une redirection du fluide caloporteur selon une deuxième direction sécante de la première direction.

Selon un aspect de l'invention, la deuxième direction est orientée en direction de la surface d'échange thermique, la deuxième direction ayant une composante sensiblement perpendiculaire à la surface d'échange thermique.

Selon un aspect de l'invention, l'au moins un guide de brassage est disposé de sorte à générer une redirection du fluide caloporteur selon une troisième direction sécante de la première direction et de la deuxième direction, la troisième direction ayant la même origine que la deuxième direction selon un premier plan perpendiculaire à la surface d'échange thermique, la troisième direction ayant une composante sensiblement perpendiculaire à la surface d'échange thermique opposée à la composante sensiblement perpendiculaire à la surface d'échange thermique de la deuxième direction selon le premier plan.

Selon un aspect de l'invention, l'ailette de refroidissement comprend :

- une première paroi s'étendant selon un deuxième plan sensiblement parallèle à la première direction et parallèle au premier plan, la première paroi étant configurée pour recevoir par conduction de la chaleur destinée à être évacuée par l'ailette de refroidissement, l'au moins un guide de brassage étant relié à la première paroi par le biais d'un premier support de fixation.

Selon un aspect de l'invention, l'ailette de refroidissement comprend :

- une deuxième paroi s'étendant selon un troisième plan parallèle au premier plan et distinct du deuxième plan, le guide de brassage étant relié à la deuxième paroi par le biais d'un deuxième support de fixation.

Selon un aspect de l'invention, le deuxième plan est parallèle au premier plan et/ou le troisième plan est parallèle du premier plan.

Selon un aspect de l'invention, le fluide caloporteur compris entre la première paroi et la deuxième paroi comprend un premier volume de fluide caloporteur disposé entre la surface d'échange thermique et une première surface guide de l'au moins un guide de brassage du fluide caloporteur et un deuxième volume de fluide caloporteur disposé au contact d'une deuxième surface guide de l'au moins un guide de brassage de fluide, la première surface guide présentant une forme concave et la deuxième surface guide présentant une forme concave par rapport à un premier segment sensiblement confondu avec l'au moins un guide de brassage de fluide et parallèle à la première direction.

Selon un aspect de l'invention, l'au moins un guide de brassage de fluide comprend une interface d'inversion du fluide caloporteur configuré pour rediriger le fluide caloporteur compris dans le deuxième volume de fluide caloporteur en direction du premier volume de fluide caloporteur.

Selon un aspect de l'invention, l'interface d'inversion du fluide caloporteur configuré pour rediriger le fluide caloporteur compris dans le premier volume de fluide caloporteur en direction du deuxième volume de fluide caloporteur.

Selon un aspect de l'invention, l'interface d'inversion du fluide caloporteur comprend une première zone d'inversion de flux reliée à la première paroi et/ou la deuxième paroi et une deuxième zone d'inversion du flux reliée à la première paroi et/ou la deuxième paroi, la première surface guide dans la première zone d'inversion étant de forme concave par rapport à la zone d'échange thermique et la deuxième surface guide dans la deuxième zone d'inversion étant de forme convexe par rapport à la surface d'échange thermique.

Selon un aspect de l'invention, la première surface guide dans la première zone d'inversion est de forme concave entre deux bornes du premier segment et la deuxième surface guide dans la deuxième zone d'inversion est de forme concave entre les deux bornes du premier segment.

Selon un aspect de l'invention, la première zone d'inversion est apte à induire une première rotation du fluide caloporteur du premier volume de fluide caloporteur et dans lequel la deuxième zone d'inversion est apte à induire une deuxième rotation du fluide caloporteur du deuxième volume de fluide caloporteur selon un axe de rotation parallèle à la première direction.

Selon un aspect de l'invention, l'au moins un guide de brassage comprend guide additionnel s'étendant perpendiculairement à la première paroi et à la deuxième paroi, le guide additionnel comprenant une première surface de guidage additionnelle en regard de la première paroi et une deuxième surface de guidage additionnelle en regard de la deuxième paroi, la première surface guidage additionnelle et la deuxième surface de guidage additionnelle présentant une forme convexe selon un deuxième segment sensiblement confondu avec le guide additionnel et parallèle à la première direction.

Selon un aspect de l'invention, la première surface guide dans la première zone d'inversion et la deuxième surface guide dans la deuxième zone d'inversion sont définies selon l'équation mathématique suivante :

$$D = f_1(X) \cdot \sin\!\big(f_2(X)\big)$$

dans laquelle $D$ représente le déplacement du fluide caloporteur par rapport à la première direction entre une entrée de l'interface d'inversion et une sortie de l'interface d'inversion selon la première direction, $X$ représente une position du fluide caloporteur le long de la première direction entre l'entrée de l'interface d'inversion et la sortie de l'interface d'inversion, $X$ étant défini à 0 arbitrairement à l'entrée dans l'interface d'inversion, $f_x$ représentent des fonctions mathématiques quelconques.

Selon un aspect de l'invention, la première surface guide dans la première zone d'inversion et la deuxième surface guide dans la deuxième zone d'inversion sont définies selon l'équation mathématique suivante :

$$D = \sum_{0}^{n} \alpha_n \cdot X^n$$

dans lequel $D$ représente le déplacement du fluide caloporteur par rapport à la première direction entre une entrée de l'interface d'inversion et une sortie de l'interface d'inversion selon la première direction, $X$ représente une position du fluide caloporteur le long de la première direction entre l'entrée de l'interface d'inversion et la sortie de l'interface d'inversion, $X$ étant défini à 0 arbitrairement à l'entrée dans l'interface d'inversion, $\alpha_n$ représente un paramètre type coefficient réel.

L'invention sera mieux comprise et d'autres avantages apparaîtront à la lecture de la description détaillée d'un mode de réalisation donné à titre d'exemple, description illustrée par le dessin joint dans lequel :

[Fig.1] la figure 1 représente une vue schématique d'un guide de brassage et une surface d'échange thermique d'une ailette de refroidissement selon l'invention ;

[Fig.2] la figure 2 représente une vue schématique d'une configuration préférentielle d'une ailette de refroidissement comprenant le guide de brassage ;

[Fig.3] la figure 3 représente une vue du dessus du guide de brassage de l'ailette de refroidissement de la figure 2 ;

[Fig.4] la figure 4 représente une interface d'inversion de flux selon l'invention ;

[Fig.5] la figure 5 représente une vue du dessus de l'interface d'inversion de flux de la figure 4 ;

[Fig.6] la figure 6 représente une vue schématique d'une première configuration de positionnement du guide de brassage selon l'invention ;

[Fig.7] la figure 7 représente une vue schématique d'une deuxième configuration de positionnement du guide de brassage selon l'invention ;

[Fig.8] la figure 8 représente une vue schématique d'une troisième configuration de positionnement du guide de brassage selon l'invention ;

[Fig.9] la figure 9 représente une vue schématique d'une quatrième configuration de positionnement du guide de brassage selon l'invention ;

[Fig.10] la figure 10 représente une vue schématique d'une cinquième configuration de positionnement du guide de brassage selon l'invention ;

[Fig.11] la figure 11 représente une vue schématique de l'interface d'inversion de flux générant une rotation du flux ;

[Fig.12] la figure 12 est une représentation spatiale du déplacement de deux fluides caloporteurs traversant l'ailette de refroidissement selon un premier modèle ;

[Fig.13] la figure 13 est une représentation spatiale du déplacement des deux fluides caloporteurs traversant l'ailette de refroidissement selon un deuxième modèle ;

[Fig.14] la figure 14 est une représentation spatiale du déplacement de deux fluides caloporteurs traversant l'ailette de refroidissement selon un troisième modèle ;

[Fig.15] la figure 15 est une représentation spatiale du déplacement de deux fluides caloporteurs traversant l'ailette de refroidissement selon un quatrième modèle.

Par souci de clarté, les mêmes éléments porteront les mêmes repères dans les différentes figures.

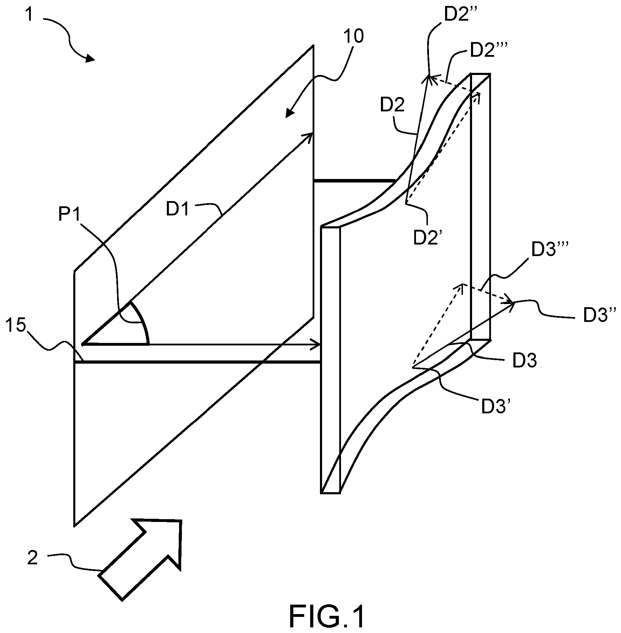

Le figure 1 représente une vue schématique agrandie d'une ailette de refroidissement 12 d'un dispositif de refroidissement 1. Le dispositif de refroidissement 1 comprend donc une multitude d'ailettes de refroidissement 12. Chaque ailette de refroidissement 12 est balayée par un fluide caloporteur 2 selon une première direction D1. Le dispositif de refroidissement présente une surface d'échange thermique 10 qui est également l'embase de l'ailette de refroidissement 12. Le dispositif de refroidissement 1 est ainsi configuré pour permettre un échange thermique avec le fluide caloporteur 2 le long de la surface d'échange thermique 10 selon la première direction D1, l'échange thermique s'opérant par convection entre la surface d'échange thermique 10 et le fluide caloporteur 2. De plus, la surface d'échange thermique 10 est également configurée pour recevoir, par conduction, de la chaleur destinée à être évacuer par l'ailette de refroidissement 12. Autrement dit, la surface d'échange thermique 10 est destinée à recevoir de la chaleur en provenance d'une source chaude par conduction. La surface d'échange thermique 10 comprend avantageusement un matériau thermiquement conducteur. Et, cette chaleur est transmise de la surface d'échange thermique 10 au fluide caloporteur 2 qui traverse l'ailette de refroidissement 12 par convection de sorte à évacuer la chaleur du dispositif de refroidissement 1, cet échange thermique se produisant principalement le long de la surface d'échange thermique 10 et à proximité de la surface d'échange thermique 10.

Or, le transfert de chaleur de la surface d'échange thermique 10 au fluide caloporteur 2 augmente localement la température du fluide caloporteur 2 à proximité de la surface d'échange thermique 10. Et, l'échange thermique étant efficient lorsque les deux corps qui échangent thermiquement sont à des températures éloignées, l'augmentation de la température du fluide caloporteur 2 localement et à proximité de la surface d'échange thermique 10 nuit à l'efficience de cette extraction de chaleur tout au long du balayage du fluide caloporteur 2 dans l'ailette de refroidissement 12.

Ainsi, avantageusement, l'ailette de refroidissement 12 comprend au moins un guide de brassage de fluide 14 fixe par rapport à la surface d'échange thermique 10. Autrement dit, l'au moins un guide de brassage 14 est solidaire et encastré par rapport à la surface d'échange thermique 10. L'au moins un guide de brassage 14 est également à distance par rapport à la surface d'échange thermique 10. L'ailette de refroidissement 12 peut ainsi comprendre une multitude de guides de brassage 14 disposés aléatoirement dans l'ailette de refroidissement 12, ou alignés parallèlement entre eux par rapport à la première direction D1 ou encore alignés entre eux selon une quelconque direction.

L'au moins un guide de brassage de fluide 14 présente également une surface gauche. Autrement dit, l'au moins un guide de brassage de fluide 14 présente une surface réglée non développable, c'est-à-dire une surface engendrée par le mouvement d'une droite, dont deux positions successives ne sont généralement pas dans un même plan. Ainsi la surface gauche du guide de brassage de fluide 14 ne répond pas à une règle de développement.

Ainsi, par l'intermédiaire de cette surface gauche, l'au moins un guide de brassage du fluide 14 est disposé de sorte à générer une redirection du fluide caloporteur 2 selon une deuxième direction D2 sécante de la première direction D1.

L'au moins un guide de brassage de fluide 14 permet alors de rediriger une partie du fluide caloporteur 2 qui traverse l'ailette de refroidissement 12 de sorte à générer un brassage du fluide caloporteur 2 entre un fluide caloporteur 2' chaud à proximité de la surface d'échange thermique 10 et un fluide caloporteur 2" plus froid par rapport au fluide caloporteur 2'. Ce mélange de fluide permet alors d'homogénéiser la température globale du fluide caloporteur 2 et donc de refroidir le fluide caloporteur 2' disposé à proximité de la surface d'échange thermique 10 et d'améliorer l'échange thermique entre la surface d'échange thermique 10, ou le corps chaud, et le fluide caloporteur 2' disposé à proximité de la surface d'échange thermique 10.

Le guide de brassage de fluide 14 permet également de générer des turbulences locales améliorant l'échange thermique.

Comme dit précédemment, le guide de brassage de fluide 14 est solidaire de la surface d'échange thermique 10. Ainsi, il peut être envisagé de solidariser le guide de brassage de fluide 14 à la surface d'échange thermique 10 par le biais d'un doigt de fixation 15 ou par le biais de plusieurs doigts de fixation 15 comme il est représenté en figure 1.

De plus, comme représenté en figure 1, la deuxième direction D2 est orientée en direction de la surface d'échange thermique 10. En effet, la deuxième direction D2 peut être définie par le biais d'une origine D2' et d'une extrémité D2". Et, l'extrémité D2" de la deuxième direction D2 est à une distance plus faible que l'origine D2' de la deuxième direction D2. Autrement dit, la deuxième direction D2 comprend une composante D2''' sensiblement perpendiculaire à la surface d'échange thermique 10.

Dès lors, l'au moins un guide de brassage de fluide 14 permet de dévier le fluide caloporteur 2 à proximité de la surface d'échange thermique de sorte à générer une oscillation dans le parcours du fluide caloporteur 2 le long de la surface d'échange thermique 10. Cette oscillation dans la parcours du fluide caloporteur 2 le long de la surface d'échange thermique 10 présente l'intérêt d'allonger la distance parcourue par le fluide caloporteur 2 le long de la surface d'échange thermique 10 et donc d'augmenter le temps d'échange thermique entre le fluide caloporteur 2 et la surface d'échange thermique 10 améliorant l'extraction de la chaleur. En outre, l'au moins une guide de brassage du fluide 14 présente également l'avantage de ne pas impacter la vitesse du fluide caloporteur 2. En effet, une accélération du fluide caloporteur 2 le long de la surface d'échange diminue le temps d'échange thermique et limite l'extraction thermique alors qu'un ralentissement de la vitesse du fluide caloporteur dans l'ailette de refroidissement 12 limite grandement l'effet de convection s'opérant entre la surface d'échange thermique 10 et le fluide caloporteur 2 de faible vitesse. Ainsi, l'au moins un guide de brassage 14 présente l'avantage d'allonger la distance parcourue par le fluide caloporteur à proximité de la surface d'échange thermique 10 sans impacter la capacité d'extraction thermique du fluide caloporteur 2.

De plus, l'au moins un guide de brassage de fluide 14 présente l'avantage de générer des zones de surpression et des zones de dépression favorisant le déplacement du fluide caloporteur 2 par rapport à la surface d'échange thermique 10 dans l'ailette de refroidissement 12.

En outre, l'au moins un guide de brassage 14 est disposé de sorte à générer une redirection du fluide caloporteur 2 selon une troisième direction D3 sécante de la première direction D1 et de la deuxième direction D2. La troisième direction D3 comprend également une origine D3' et une extrémité D3". Et, l'origine D3' de la troisième direction D3 est superposée à l'origine D2' de la deuxième direction D2 selon un premier plan P1 parallèle à la première direction D1 et perpendiculaire à la surface d'échange thermique 10. Autrement dit, dans le premier plan P1, la deuxième direction D2 et la troisième direction D3 ont la même origine, c'est-à-dire que l'origine D2' de la deuxième direction D2 et l'origine D3' de la troisième direction sont confondues.

Et, de manière similaire à la deuxième direction D2, la troisième direction D3 a une composante D3''' sensiblement perpendiculaire à la surface d'échange thermique 10 et opposée à la composante D2''' sensiblement perpendiculaire à la surface d'échange thermique 10 de la deuxième direction D2 dans le premier plan P1. Autrement dit, l'origine D3' de la troisième direction D3 est à une distance plus faible que l'extrémité D3" de la troisième direction D3" de sorte que la troisième direction D3 est orienté pour ne pas faire face à la surface d'échange thermique 10.

Ainsi, l'au moins un guide de brassage de fluide 14 présente l'avantage de permettre de rediriger le fluide caloporteur 2 dans deux directions sécantes, voire opposées, par le biais de la deuxième direction D2 et la troisième direction D3 de manière simultanée pour le fluide caloporteur 2 en contact avec l'au moins un guide de brassage de fluide 14. Plus précisément, l'au moins un guide de brassage de fluide 14 est apte à rediriger le fluide caloporteur 2' chaud qui se trouve à proximité de la surface d'échange thermique 10 selon la troisième direction D3 de sorte à éloigner le fluide caloporteur 2' chaud de la surface d'échange thermique 10 et à rediriger le fluide caloporteur 2" froid à distance de la surface d'échange thermique 10 selon la deuxième direction D2 de sorte à le rapprocher de la surface d'échange thermique 10, ces deux redirections se faisant de façon simultanée c'est-à-dire que pour un fluide entrant en contact avec l'au moins un guide de brassage de fluide 14, la redirection selon la deuxième direction D2 et selon la troisième direction D3 ne se fait pas de manière successive mais bien au même moment.

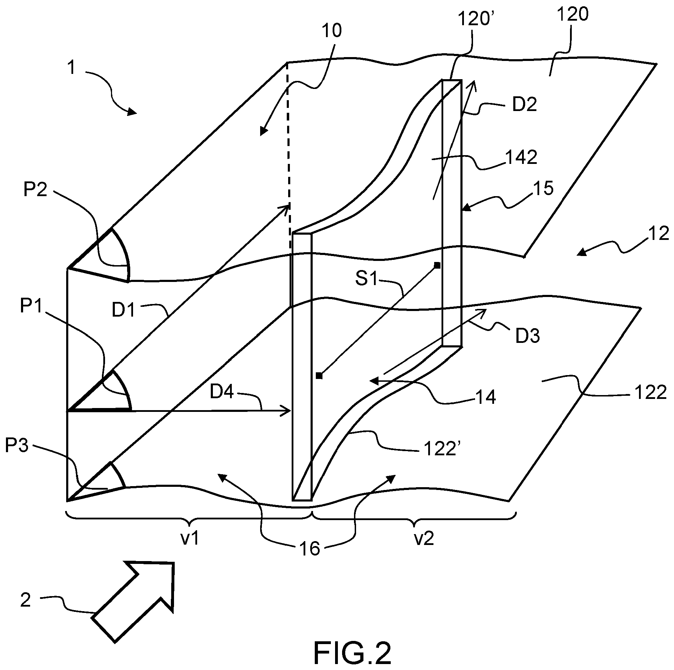

Selon une configuration représentée en figure 2, l'ailette de refroidissement 12 peut également comprendre une première paroi 120 s'étendant selon un deuxième plan P2 sensiblement parallèle à la première direction D1 et au premier plan P1. La première paroi 120 est configurée pour recevoir par conduction de la chaleur de la surface d'échange thermique 10 destinée à être évacuée par l'ailette de refroidissement 12. En outre, la première paroi 120 comprend un matériau thermiquement conducteur.

L'au moins un guide de brassage de fluide 14 est relié à la première paroi 120 par le biais d'un premier support de fixation 120'. La première paroi 120 devient également conductrice de chaleur de sorte à répartir la chaleur à évacuer sur une plus grande surface, à savoir la surface d'échange thermique 10 et la première paroi 120 tout en améliorant la solidarisation de l'au moins un guide de brassage 14 par rapport à la surface d'échange thermique 10.

Il peut également être envisagée que l'ailette de refroidissement 12 comprenne une deuxième paroi 122 s'étendant selon un troisième plan P3 sensiblement parallèle à la première direction D1 et au premier plan P1. Le troisième plan P3 est distinct et parallèle au deuxième plan P2. La deuxième paroi 122 est configurée pour recevoir par conduction de la chaleur de la surface d'échange thermique 10 destinée à être évacuée par l'ailette de refroidissement 12. En outre, la deuxième paroi 122 comprend un matériau thermiquement conducteur.

L'au moins un guide de brassage de fluide 14 est relié à la deuxième paroi 122 par le biais d'un deuxième support de fixation 122'. La deuxième paroi 122 devient également conductrice de chaleur de sorte à répartir la chaleur à évacuer sur une plus grande surface, à savoir la surface d'échange thermique 10, la première paroi 120 et la deuxième paroi 122 tout en améliorant la solidarisation de l'au moins un guide de brassage 14 par rapport à la surface d'échange thermique 10.

La première paroi 120 et la deuxième paroi 122 forment alors une cavité 16 dans laquelle le fluide caloporteur 2 s'introduit et dans laquelle l'au moins un guide de brassage de fluide 14 se développe.

En variante, il peut également être envisagé que la première paroi 120 ou la deuxième paroi 122 ne s'étendent pas perpendiculairement par rapport à la surface d'échange thermique 10. Plus précisément, il peut être envisagé que le deuxième plan P2 et/ou la troisième plan P3 s'étendent selon un plan sécant par rapport au premier plan P1 de sorte à générer une forme d'ailette de refroidissement 12 en triangle ou en triangle inversé.

Le fluide caloporteur 2 est ainsi compris entre la première paroi 120 et la deuxième paroi 122 et, plus précisément, peut être compris dans un premier volume v1 de fluide caloporteur disposé entre la surface d'échange thermique 10 et une première surface guide 140 de l'au moins un guide de brassage 14 du fluide caloporteur et un deuxième volume v2 de fluide caloporteur disposé au contact d'une deuxième surface guide 142 de l'au moins un guide de brassage de fluide 14. La première surface guide 140 de l'au moins un guide de brassage de fluide 14 fait face à la surface d'échange thermique 10 alors que la deuxième surface guide 142 de l'au moins un guide de brassage de fluide 14 est opposée à la première surface guide 140 selon une quatrième direction D4 perpendiculaire à la première direction D1 et parallèle au premier plan P1. La cavité 16 est donc composée du premier volume v1 et du deuxième volume v2. Le premier volume v1 représente donc un volume de fluide caloporteur 2' chaud et à proximité de la surface d'échange thermique 10 alors que le volume v2 représente un volume de fluide caloporteur 2" froid se trouvant à distance de la surface d'échange thermique 10 en comparaison du fluide caloporteur 2'.

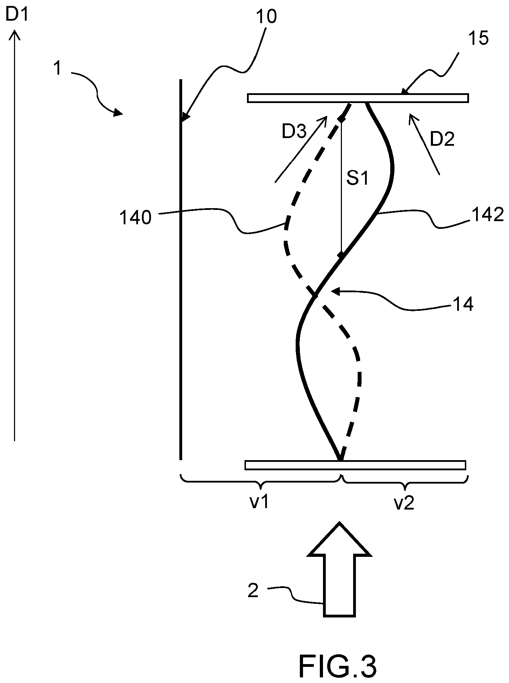

Comme représenté en figure 3, la première surface guide 140 présente une forme concave par rapport à un premier segment S1 sensiblement confondu avec l'au moins un guide de brassage de fluide 14, parallèle à la première direction D1 et compris dans le premier plan P1. Et, la deuxième surface guide 142 présente une forme concave par rapport au premier segment S1. Ainsi, par rapport à la surface d'échange thermique 10, la première surface guide 140 présente une forme convexe alors que la deuxième surface guide 142 présente une forme concave. Ainsi, la forme concave de la première surface guide 140 permet d'orienter le fluide caloporteur 2' chaud du premier volume v1 vers la troisième direction D3 alors que la forme concave de la deuxième surface guide 142 permet d'orienter le fluide caloporteur 2" froid du deuxième volume v2 vers la deuxième direction D2.

En variante, il peut également être envisagé que la première surface guide 140 et que la deuxième surface guide 142 présente une forme sensiblement planaire, la forme planaire de la première surface guide 140 étant parallèle à la troisième direction D3 et la forme planaire de la deuxième surface guide 142 est parallèle à la deuxième direction D2.

Ainsi, par l'intermédiaire de sa surface gauche non réglée, le guide de brassage de fluide 14 permet d'induire une redirection du fluide caloporteur 2 selon au moins deux directions, à savoir la deuxième direction D2 et la troisième direction D3 et donc de brasser le fluide caloporteur chaud 2' avec le fluide caloporteur froid 2" de sorte à réduire la température locale du fluide caloporteur 2 à proximité de la surface d'échange thermique 10.

Plus précisément, le guide de brassage de fluide 14 comprend une interface d'inversion 15 du fluide caloporteur configuré pour rediriger le fluide caloporteur froid 2" compris dans le deuxième volume v2 de fluide caloporteur en direction du premier volume v1 de fluide caloporteur. L'interface d'inversion 15 permet de générer une inversion de position du fluide caloporteur 2 traversant l'ailette de refroidissement 12. En effet, l'interface d'inversion 15 permet de déplacer de manière simultanée le fluide caloporteur froid 2" du deuxième volume v2 dans le premier volume v1. Autrement dit, l'interface d'inversion 15 de fluide permet de déplacer le fluide caloporteur froid 2" à distance de la surface d'échange thermique 10 compris dans le deuxième volume v2 dans le premier volume v1 et donc de rapprocher le fluide caloporteur froid 2" de la surface d'échange thermique 10. En effet, au niveau de l'interface d'inversion 15 de fluide, la forme concave de la deuxième surface guide 142 permet d'orienter le fluide caloporteur froid 2" en direction de la deuxième direction D2 qui est orientée vers la surface d'échange thermique 10 et donc vers le premier volume v1.

En outre, l'interface d'inversion 15 du fluide caloporteur peut également être configurée pour rediriger le fluide caloporteur 2' chaud compris dans le premier volume v1 de fluide caloporteur en direction du deuxième volume v2 de fluide caloporteur. Or, comme énoncé précédemment, l'interface d'inversion 15 permet de déplacer de manière simultanée le fluide caloporteur chaud 2' du premier volume v1 dans le deuxième volume v2. Autrement dit, l'interface d'inversion 15 de fluide permet de déplacer le fluide caloporteur chaud 2' à proximité de la surface d'échange thermique 10 compris dans le premier volume v1 dans le deuxième volume v2 et donc d'éloigner le fluide caloporteur chaud 2' de la surface d'échange thermique 10. En effet, au niveau de l'interface d'inversion 15 de fluide, la forme concave de la première surface guide 140 permet d'orienter le fluide caloporteur chaud 2' en direction de la troisième direction D3 qui est orientée de façon sensiblement opposée à la surface d'échange thermique 10 et donc vers le deuxième volume v2.

Ainsi, l'interface d'inversion 15 permet de déplacer de manière simultanée deux volumes superposés par rapport à la surface d'échange thermique 10, à savoir le premier volume v1 et le deuxième volume v2 et d'inverser la position des deux volumes par rapport à la surface d'échange thermique 10 de sorte que le volume de fluide caloporteur le plus éloigné de la surface d'échange, à savoir le deuxième volume v2 selon la configuration représentée en figure 3, se retrouve à proximité de la surface d'échange thermique 10 et que le volume le plus proche de la surface d'échange thermique 10, à savoir le premier volume, et compris initialement entre la surface d'échange thermique 10 et le volume le plus éloigné de la surface d'échange thermique 10 se retrouve éloigné de la surface d'échange thermique 10. Dès lors, après le passage du fluide caloporteur 2 dans l'interface d'inversion 15, c'est le deuxième volume de fluide caloporteur v2 qui se retrouve compris entre la surface d'échange thermique 10 et le premier volume de fluide caloporteur v1.

En effet, l'échange de la chaleur en provenance de la surface d'échange thermique 10 et en direction du fluide caloporteur 2 à proximité de la surface d'échange thermique 10 augmente la température du fluide caloporteur 2 compris dans le premier volume v1. Dès lors, l'interface d'inversion 15 permet de remplacer le fluide caloporteur chaud 2' compris dans le premier volume v1 dont la capacité d'extraction thermique est faible par le fluide caloporteur 2" plus froid compris dans le deuxième volume v2 afin d'améliorer l'échange thermique entre le fluide caloporteur 2 et la surface d'échange thermique 10.

L'inversion des deux volumes de fluide caloporteur, à savoir le premier volume v1 et le deuxième volume v2 présente l'avantage de permettre de positionner à proximité de la surface d'échange thermique un fluide caloporteur 2 le plus froid disponible tout du long de l'échange de chaleur entre la surface d'échange thermique 10 et le fluide caloporteur 2 en remplaçant un fluide caloporteur chaud 2' par un fluide caloporteur 2" plus froid en comparaison, l'échange par convection se faisant principalement à proximité de la surface d'échange thermique. Dès lors, le gradient thermique entre la surface d'échange thermique 10 et le fluide caloporteur 2 disposé à proximité de la surface d'échange thermique reste élevé améliorant l'extraction de la chaleur.

En outre, le fait d'éloigner le fluide caloporteur chaud 2' compris initialement dans le premier volume v1, et dont la capacité d'extraction thermique est alors faible, permet également à ce fluide caloporteur de se refroidir au contact d'un milieu plus frais par rapport à la surface d'échange thermique 10. Il est alors possible d'envisager d'inverser de manière répétée et régulière le fluide caloporteur 2 compris dans le premier volume v1 et dans le deuxième volume v2 de sorte à améliorer l'extraction de chaleur pendant la traversée du fluide caloporteur 2 dans l'ailette de refroidissement selon la première direction D1.

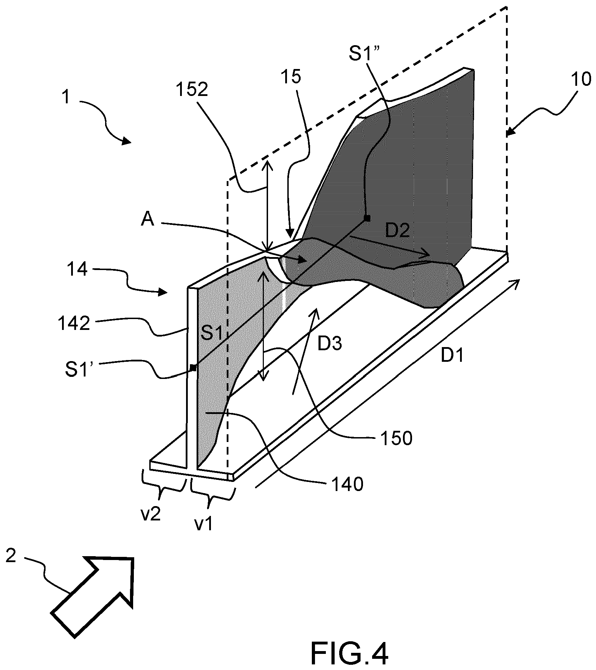

La figure 4 représente une vue agrandie de l'interface d'inversion 15 de fluide et de la première paroi 120 de l'ailette de refroidissement 12. L'interface d'inversion 15 permet ainsi d'inverser la position du fluide caloporteur 2 compris dans le premier volume v1 et dans le deuxième volume v2 en orientant simultanément le fluide caloporteur 2 selon la deuxième direction D2 et selon la troisième direction D3. L'interface d'inversion 15 du fluide caloporteur comprend une première zone d'inversion 150 de flux reliée à la première paroi 120 et une deuxième zone d'inversion 152 du flux reliée également à la première paroi 120.

Il peut être envisagé, dans une configuration d'ailette de refroidissement 12 comprenant également la deuxième paroi 122, que la première zone d'inversion 150 et/ou que la deuxième zone d'inversion 152 soient uniquement reliées à la deuxième paroi ou encore que la première zone d'inversion 150 et/ou que la deuxième zone d'inversion 152 soient reliées à la première paroi 120 et à la deuxième paroi 122.

Ainsi, dans la première zone d'inversion 150, la première surface guide 140 est de forme convexe par rapport à la zone d'échange thermique 10 et concave par rapport au premier segment S1. Et, dans la deuxième zone d'inversion 152, la deuxième surface guide 142 est de forme concave par rapport au premier segment S1 et par rapport à la surface d'échange thermique 10.

Autrement dit, la première surface guide 140 dans la première zone d'inversion 150 est de forme concave entre deux bornes S1' et S1" du premier segment S1 et la deuxième surface guide 142 dans la deuxième zone d'inversion 152 est de forme concave entre les deux bornes S1' et S1" du premier segment S1 obtenues par la forme gauche et non réglée du guide de brassage 14.

Ainsi, le guide de brassage 14 permet de générer deux couloirs rectilignes superposés et parallèles à la surface d'échange thermique 10 et l'interface d'inversion 15 permet d'inverser la position de ces deux couloirs rectilignes, à savoir le premier volume v1 et le deuxième volume v2, par rapport à la surface d'échange thermique 10 sans que le fluide caloporteur compris dans l'un des volumes parmi le premier volume v1 ou le deuxième volume v2 soit en contact du fluide caloporteur compris dans l'autre volume parmi le premier volume v1 ou le deuxième volume v2, à l'image d'une chicane de redirection.

L'interface d'inversion 15 présente ainsi l'avantage de permettre d'obtenir une inversion en un seul mouvement, la déviation du fluide caloporteur dans le premier volume v1 et la déviation du fluide caloporteur dans le deuxième fluide v2 se faisant de manière simultanée, et non pas de manière successive le long de la surface d'échange thermique 10.

Autrement dit l'interface d'inversion 15 permet d'inverser la position du premier volume v1 et du deuxième volume v2 à un point A unique par rapport à la surface d'échange thermique 10 limitant ainsi le nombre de composants ou formes nécessaires pour procéder à l'inversion de la position des flux caloporteurs 2 dans l'ailette de refroidissement 12.

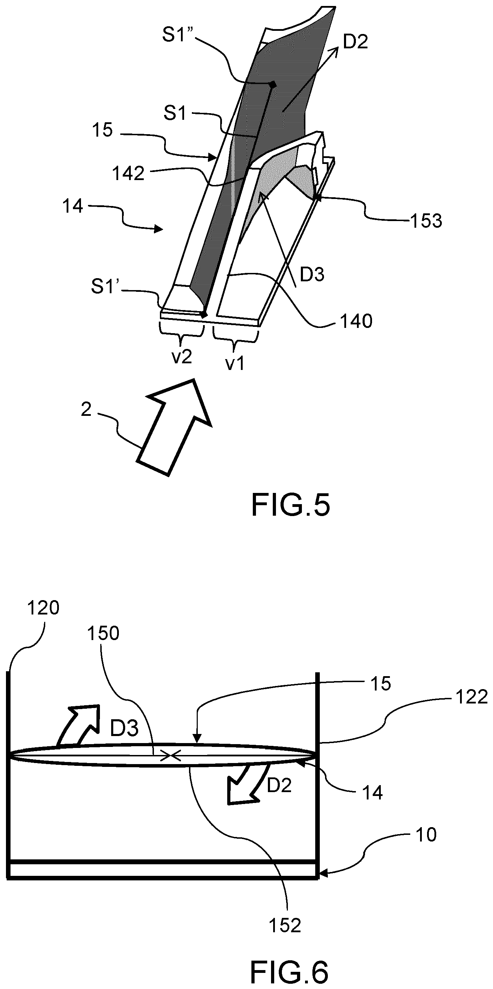

La figure 5 représente une vue agrandie de l'interface d'inversion 15 sous un angle du dessus.

Ainsi, comme énoncé précédemment, l'interface d'inversion 15 permet d'inverser la position de ces deux couloirs rectilignes, à savoir le premier volume v1 et le deuxième volume v2, par rapport à la surface d'échange thermique 10 sans que le fluide caloporteur compris dans l'un des volumes parmi le premier volume v1 ou le deuxième volume v2 soit en contact du fluide caloporteur compris dans l'autre volume parmi le premier volume v1 ou le deuxième volume v2, à l'image d'une chicane de redirection. Cette chicane permet de diriger le fluide caloporteur frais 2" selon la deuxième direction D2 à proximité de la surface d'échange thermique 10 et le fluide caloporteur chaud 2' selon la troisième direction D3 de sorte à l'éloigner de la surface d'échange thermique 10. Afin de générer cette redirection du fluide caloporteur 2 selon la deuxième direction D2 ou selon la troisième direction D3, l'interface d'inversion 15 du fluide peut comprendre une butée d'orientation 153 permettant de faire barrage au fluide caloporteur et de diriger le fluide caloporteur dans la troisième direction D3 comme représentée en figure 5. En outre, il peut également être envisagé une butée d'orientation permettant de diriger le fluide caloporteur compris dans le deuxième volume v2 dans la deuxième direction D2. La butée d'orientation 153 permet donc d'orienter davantage le fluide caloporteur 2 en cumulant un moyen supplémentaire en plus de la première surface guide 140 dans la première zone d'inversion 150.

En outre, plusieurs configurations peuvent être envisagées.

Il peut être envisagé, comme représenté en figure 6, que l'interface d'inversion 15 et le guide de brassage 14 soient disposés parallèlement par rapport à la surface d'échange thermique 10. Dès lors, la première paroi 120 est connectée à la première zone d'inversion 150, qui est reliée également à la deuxième zone d'inversion 152. Et, la deuxième zone d'inversion 152 est connectée à la deuxième paroi 122.

Selon une autre configuration architecturale, il peut également être envisagé que le guide de brassage de fluide 14 et que l'interface d'inversion 15 soient reliés à la surface d'échange thermique 10. Dès lors, la première zone d'inversion 150 peut être reliée à la surface d'échange thermique 10 et à la deuxième zone d'inversion 152.

Cette configuration présente l'avantage de permettre au guide de brassage de fluide 14 d'être également conducteur de chaleur. Dès lors, le fluide caloporteur 2 au contact du guide de brassage 14 et de l'interface d'inversion 15 peut également permettre un échange de chaleur avec le fluide caloporteur 2.

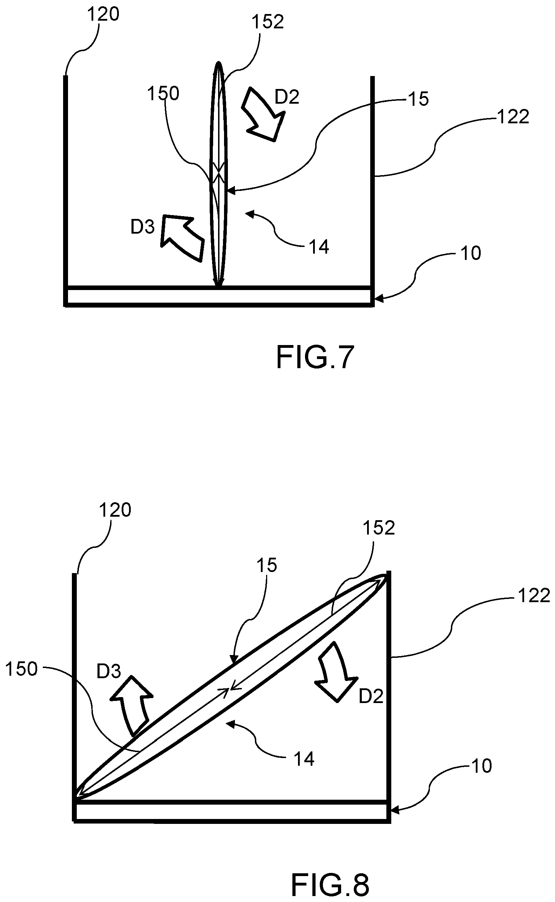

Selon une configuration représentée en figure 8, il peut être envisagé que le guide de brassage de fluide 14 et que l'interface d'inversion 15 soient reliés à la surface d'échange thermique 10 et aux parois 120 et 122 de l'ailette de refroidissement. Dès lors, la première zone d'inversion 150 peut être reliée à la surface d'inversion thermique 10 alors que la deuxième zone d'inversion 152 peut être reliée à la deuxième paroi 122. Cette configuration présente l'avantage de permettre une bonne conduction thermique dans le guide de brassage 14 tout en permettant une bonne fixation du guide de brasage 14 dans l'ailette de refroidissement. En variante, il peut être envisagé que la première zone d'inversion 150 soit reliée à la première paroi 120 et à distance faible de la surface d'échange thermique 10. Selon une autre variante, la deuxième zone d'inversion 152 peut être reliée à la surface d'échange thermique 10 et la première zone d'inversion 150 est reliée à la première paroi 120.

Selon une autre configuration représentée en figure 7, il peut également être envisagé que l'interface d'inversion 15 comprenne plus de deux zones d'inversions. A titre d'exemple indicatif, l'interface d'inversion 15 peut comprendre la première zone d'inversion 150, la deuxième zone d'inversion 152 et une troisième zone d'inversion 152' permettant de diriger le flux caloporteur selon une direction D2' orientée vers la surface d'échange thermique 10. En outre, la première zone d'inversion 150 peut être comprise entre la deuxième zone d'inversion 152 et la troisième zone d'inversion 152' permettant de répartir de façon plus homogène le fluide caloporteur froid 2" à proximité de la surface d'échange thermique 10.

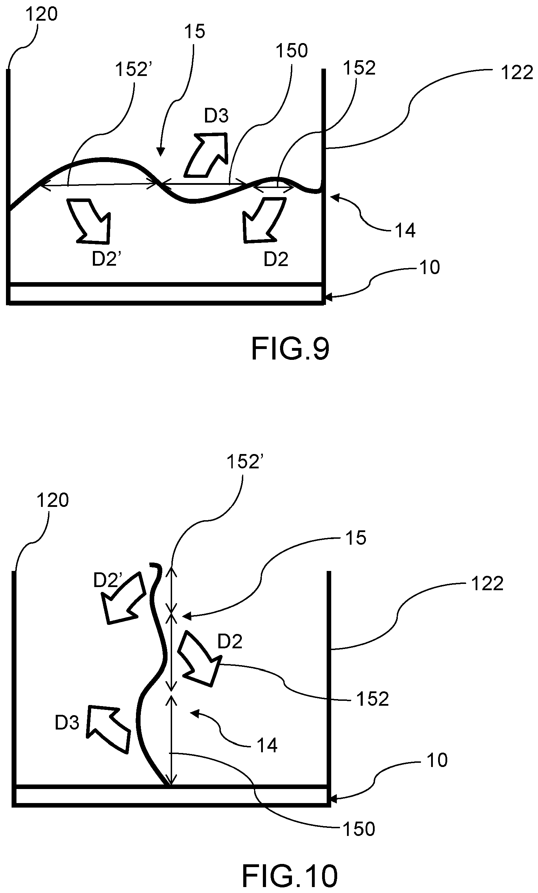

Selon une autre configuration représentée en figure 10, il peut également être envisagé de relier l'interface d'inversion 15 de la figure 9 directement à la surface d'échange thermique 10 afin que le guide de brassage de fluide 14 soit conducteur de chaleur. En outre, selon cette configuration de guide de brassage 14 parallèle aux parois de l'ailette de refroidissement 12, il peut être envisagé que la deuxième zone d'inversion 152 soit comprise entre la première zone d'inversion 150 et la troisième zone d'inversion 152'. A la différence de la configuration de la figure 9, la troisième zone d'inversion 152' est disposée de sorte que la direction D2' est sécante de la troisième direction D3. Dès lors, le fluide caloporteur 2 réorienté par la troisième zone d'inversion 152' entre en contact avec le fluide caloporteur chaud 2' réorienté par la première zone d'inversion 150 de sorte à refroidir le fluide caloporteur chaud 2'. Ainsi, il y a interversion des fluides caloporteurs par le biais de la première zone d'inversion 150 et de la deuxième zone d'inversion 152 et il y a également un brassage de fluide caloporteur pour refroidir le fluide caloporteur chaud qui se trouvait initialement à proximité de la surface d'échange thermique 10 de sorte à le refroidir le plus efficacement possible.

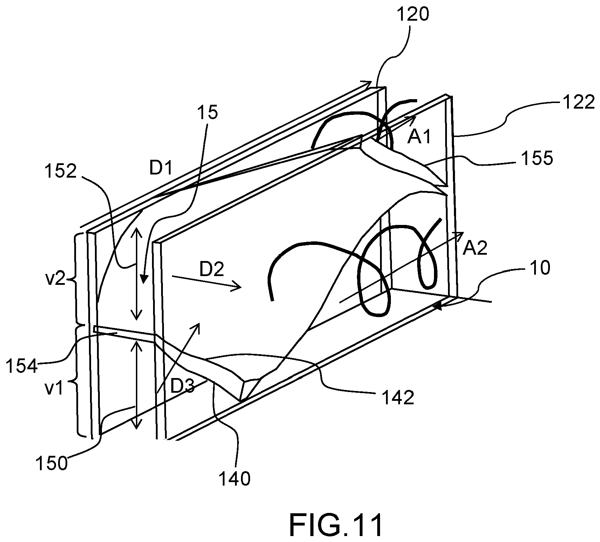

De plus, il peut être envisagé, comme représenté en figure 11, que la première zone d'inversion 150 soit apte à induire une première rotation du fluide caloporteur 2' chaud du premier volume v1 de fluide caloporteur selon un axe de rotation A1 parallèle à la première direction D1 et que la deuxième zone d'inversion 152 est apte à induire une deuxième rotation du fluide caloporteur 2" froid du deuxième volume v2 de fluide caloporteur 2 selon un axe de rotation A2 parallèle à la première direction D1. Dès lors, la génération d'une rotation ou d'un mouvement hélicoïdale autour de l'axe de rotation A2 présente l'avantage d'améliorer le brassage du fluide caloporteur à proximité de la surface d'échange thermique 10 permettant d'obtenir une température homogène dans le premier volume v1. En outre, ce type de mouvement hélicoïdal présente également l'avantage d'allonger la distance parcourue par le fluide caloporteur 2 le long de la surface d'échange thermique 10 et donc d'allonger le temps d'échange thermique par convection.

La configuration de la figure 11 représente une configuration préférentielle d'inversion du flux entre un flux qui est éloigné de la surface d'échange thermique 10 et un flux qui en est proche de la surface d'échange thermique, puis qui s'inversent par l'action de l'interface d'inversion 15.

En outre, selon une configuration où la première paroi 120 et/ou la deuxième paroi 122 est conductrice de chaleur, le fait de générer une rotation du fluide caloporteur permet d'orienter le fluide caloporteur à proximité de la surface d'échange thermique 10 et en direction de la première paroi 120 et/ou de la deuxième paroi 122.

Selon une variante, l'au moins un guide de brassage 14 peut également comprendre un guide additionnel s'étendant perpendiculairement à la première paroi 120 et à la deuxième paroi 122. Le guide additionnel comprend alors une première surface de guidage additionnelle en regard de la première paroi 120 et/ou une deuxième surface de guidage additionnelle en regard de la deuxième paroi 122. La première surface guidage additionnelle et la deuxième surface de guidage additionnelle peuvent alors présenter une forme convexe par rapport au premier segment S1 sensiblement parallèle à la première direction D1. Le guide additionnel présente ainsi la forme d'une excroissance de matière s'étendant de l'au moins un guide de brassage 14 en direction de la première paroi 120 ou de la deuxième paroi 122 et permet ainsi à une partie du fluide caloporteur 2 compris dans le premier volume v1 ou dans le deuxième volume v2 d'être respectivement dirigé vers la première paroi 120 ou vers la deuxième paroi 122 afin d'augmenter les contacts et l'échange thermique entre le fluide caloporteur 2 et la première paroi 120 et/ou la deuxième paroi 122. En variante, la première surface guidage additionnelle et la deuxième surface de guidage additionnelle peuvent alors présenter une forme convexe par rapport au premier segment S1.

Afin de générer ce mouvement de rotation du fluide caloporteur 2 dans le premier volume v1 et dans le deuxième volume v2, la première surface guide 140 dans la première zone d'inversion 150 et la deuxième surface guide 142 dans la deuxième zone d'inversion 152 peuvent être définies selon l'équation mathématique suivante :

$$D = f_1(X) \cdot \sin\big(f_2(X)\big)$$

Où $D$ représente le déplacement du fluide caloporteur 2 par rapport à la première direction D1 entre une entrée 154 de l'interface d'inversion 15 et une sortie 155 de l'interface d'inversion 15 selon la première direction D1, $X$ représente une position du fluide caloporteur 2 le long de la première direction D1 entre l'entrée 154 de l'interface d'inversion 15 et la sortie 155 de l'interface d'inversion 15, $X$ étant défini à 0 arbitrairement à l'entrée 154 dans l'interface d'inversion 15, $f_x$ représentent des fonctions mathématiques quelconques.

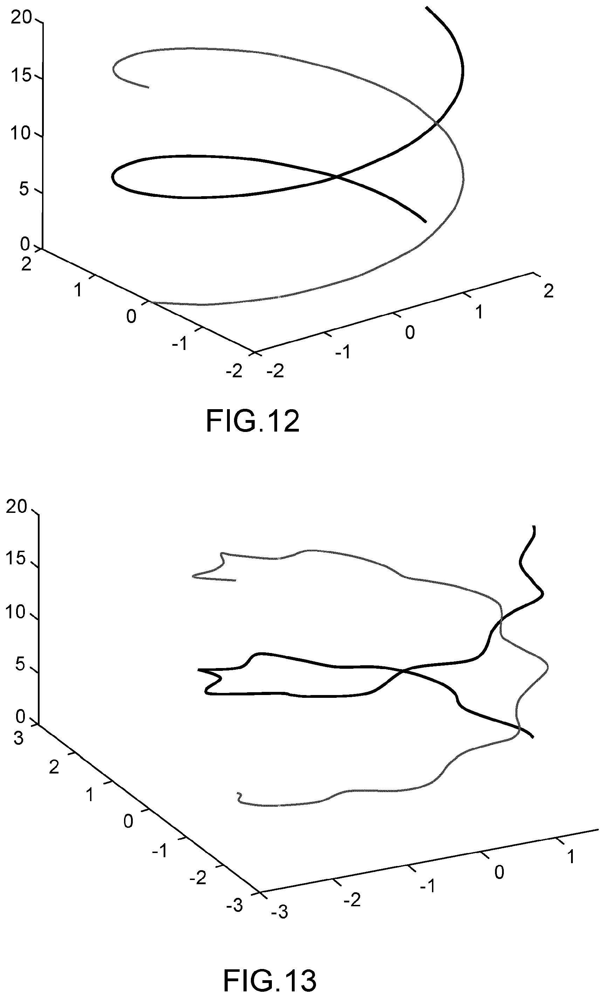

Dès lors il est possible d'obtenir deux mouvements de rotation ou hélicoïdaux selon les axes de rotation A1 et A2, comme représenté en figure 12.

De plus, il peut également être envisagé d'ajouter une courbe d'oscillation au mouvement hélicoïdale du fluide caloporteur des premier et deuxième volumes v1 et v2.

Par exemple, en reprenant l'équation précédente, il est possible d'obtenir une porteuse comme représenté en figure 12 selon la formule suivante :

$$Porteuse = Amplitude \cdot \sin(2 \cdot \pi \cdot Fréquence \cdot t)$$

Où t représente le temps et l'Amplitude représente l'Amplitude de la porteuse et donc du mouvement hélicoïdal.

Plus précisément, il est possible de définir le mouvement d'un premier fluide caloporteur, par exemple le fluide caloporteur du premier volume v1 redirigé en direction du deuxième volume v2, selon les équations suivantes :

$$x = \alpha \cdot \cos(t)$$

$$y = \beta \cdot \sin(t)$$

$$z = \gamma \cdot t$$

Où $\alpha \beta \gamma$ représentent des coefficients réel, et $x$ et $y$ représentent les coordonnées cartésiennes du premier fluide caloporteur dans un plan perpendiculaire à la première direction D1 du fluide caloporteur dans l'ailette de refroidissement 12 et $z$ représente la coordonnée cartésienne du premier fluide caloporteur parallèlement à la première direction D1.

Et, il est possible de définir le mouvement d'un deuxième fluide caloporteur, par exemple le fluide caloporteur du deuxième volume v2 redirigé en direction du premier volume v2, selon les équations suivantes :

$$x' = \alpha \cdot \cos(t + \pi)$$

$$y' = \beta \cdot \sin(t + \pi)$$

$$z' = \gamma \cdot t$$

Avec un décalage de $\pi$ entre la position du premier fluide caloporteur et du deuxième fluide caloporteur dans le plan perpendiculaire à la première direction D1 et où $x'$ et $y'$ représentent les coordonnées cartésiennes du deuxième fluide caloporteur dans un plan perpendiculaire à la première direction D1 du fluide caloporteur dans l'ailette de refroidissement 12 et *z'* représente la coordonnée cartésienne du deuxième fluide caloporteur parallèlement à la première direction D1.

Et, en ajoutant une sur-modulation en fréquence, il est possible d'obtenir un mouvement hélicoïdal d'oscillation comme représenté en figure 13. A titre d'exemple indicatif, cette sur-modulation peut être obtenue en multipliant la précédente formule à un modulateur :

*PorteuseModulée*

$$= [Amplitude + amplitude_{modulation} \cdot \sin(2 \cdot \pi \cdot fréquence_{modulation} \cdot t + \varphi)] \times \sin(2 \cdot \pi \cdot Fréquence \cdot t + \varphi)$$

*amplitude_{modulation}* représente l'amplitude de la modulation appliquée à la porteuse, c'est-à-dire la variation d'amplitude dans l'hélicoïde et *fréquence_{modulation}* représente la fréquence de la modulation appliquée à l'hélicoïde.

Dès lors, le mouvement du premier fluide caloporteur peut être défini selon les équations suivantes :

$$x = (A + a * cos(2 * pi * f * t + \varphi)).* cos(2 * pi * F * t + \varphi);$$

$$y = (A + a * sin(2 * pi * f * t + \varphi)).* sin(2 * pi * F * t + \varphi);$$

$$z = \gamma * t;$$

Où *A* représente l'amplitude du mouvement hélicoïdal du premier fluide caloporteur comme représenté en figure 12 et a représente l'amplitude de la modulation appliquée à la porteuse, *f* représente la fréquence de la modulation appliquée à l'hélicoïde et *F* représente la fréquence de la porteuse, c'est-à-dire du mouvement hélicoïdal du premier fluide caloporteur comme représenté en figure 12.

Et, le mouvement du deuxième fluide caloporteur peut être défini selon les équations suivantes :

$$x' = (A + a * cos(2 * pi * f * t + \varphi + \pi)).* cos(2 * pi * F * t + \varphi + \pi);$$

$$y' = (A + a * sin(2 * pi * f * t + \varphi + \pi)).* sin(2 * pi * F * t + \varphi + \pi);$$

$$z' = \gamma * t;$$

Avec un décalage de $\pi$ entre la position du premier fluide caloporteur et du deuxième fluide caloporteur dans le plan perpendiculaire à la première direction D1.

Cette sur-modulation présente l'avantage de permettre d'obtenir une oscillation du fluide caloporteur à proximité de la surface d'échange thermique, c'est-à-dire un allongement de la distance parcourue par le fluide caloporteur 2 le long de la surface d'échange thermique et donc un meilleur échange avec la surface d'échange thermique 10. Ce mouvement hélicoïdal selon un axe de rotation accompagné d'une oscillation selon un axe radial à l'axe de rotation présente également l'avantage d'avoir une meilleure utilisation du volume disponible dans l'ailette de refroidissement pour le brassage ce qui permet une amélioration de l'homogénéité de la température.

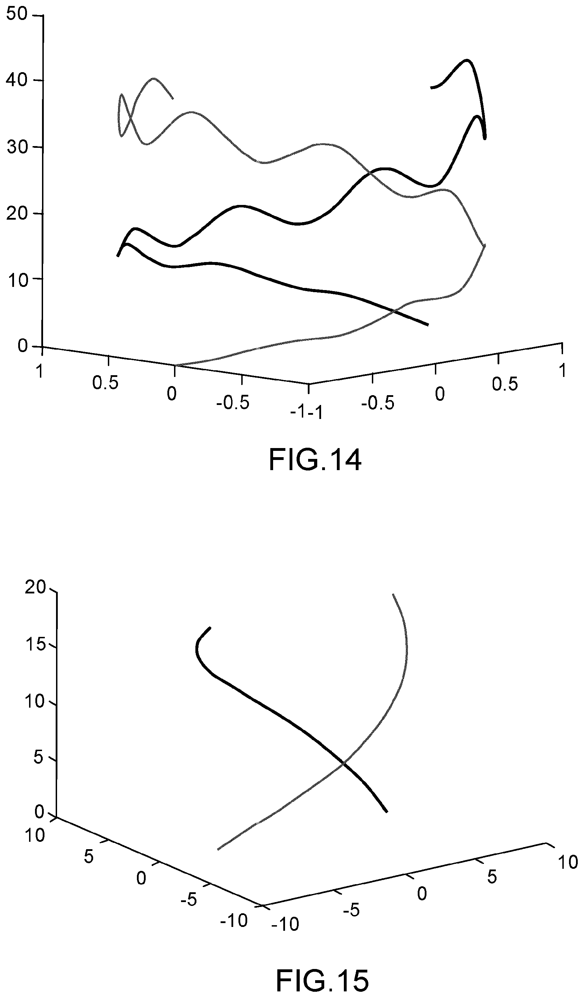

En outre, l'oscillation est dans le plan de l'hélice. Il peut également être envisagé d'ajouter une oscillation complémentaire dans le sens de l'écoulement du fluide caloporteur, parallèlement à la première direction D1 comme représenté en figure 14, en combinant une modulation dans le plan de la première direction D1 à la formule d'obtention de la porteuse énoncée précédemment.

Dès lors, le mouvement du premier fluide caloporteur peut être défini selon les équations suivantes :

$$x = cos(2 * pi * F * t + \varphi);$$

$$y = sin(2 * pi * F * t + \varphi);$$

$$z = (A + a * cos(2 * pi * f * t + \varphi + \pi)) * (\gamma * t) ;$$

Et, le mouvement du deuxième fluide caloporteur peut être défini selon les équations suivantes :

$$x' = cos(2 * pi * F * t + \varphi + \pi);$$

$$y' = sin(2 * pi * F * t + \varphi + \pi);$$

$$z' = (A + a * sin(2 * pi * f * t + \varphi + \pi)). * (20 * t) ;$$

Nous obtenons alors un mouvement hélicoïdal couplé à un mouvement sinusoïdal.

En variante, il peut également être envisagé de générer par le biais de l'interface d'inversion 15 un mouvement de type polynomial. La première surface guide 140 dans la première zone d'inversion 150 et la deuxième surface guide 142 dans la deuxième zone d'inversion 152 peuvent être définies selon l'équation mathématique suivante :

$$D = \sum_{0}^{n} \alpha_n \cdot X^n$$

dans lequel $D$ représente le déplacement du fluide caloporteur par rapport à la première direction D1 entre l'entrée 154 de l'interface d'inversion 15 et la sortie 155 de l'interface d'inversion 15 selon la première direction D1, $X$ représente une position du fluide caloporteur 2 le long de la première direction D1 entre l'entrée 154 de l'interface d'inversion 15 et la sortie 155 de l'interface d'inversion 15, $X$ étant défini à 0 arbitrairement à l'entrée dans l'interface d'inversion 15, $\alpha_n$ représente un paramètre type coefficient réel.

Dès lors, il peut être envisagé d'induire un mouvement hybride par rapport au mouvement rotationnel induit au premier fluide caloporteur et au deuxième fluide caloporteur comme indiqué aux figures 12 à 14.

Ainsi, comme représenté en figure 15, le mouvement du premier fluide caloporteur peut être défini selon les équations suivantes :

$$x = A * cos(\pi * t) ;$$

$$y = A * sin(\pi * t) ;$$

$$z = H * t ;$$

Alors que le mouvement du deuxième fluide caloporteur peut être défini selon les équations suivantes :

$$x' = A * cos(\pi * t + \pi) ;$$

$$y' = A * sin(\pi * t + \pi) ;$$

$$z' = H * t ;$$

Avec un décalage de $\pi$ dans le plan perpendiculaire par rapport à la première direction D1.

Ce mouvement peut alors être assimilé comme similaire à une architecture de type ADN.

Selon un aspect de l'invention, le fluide caloporteur 2 peut être avantageusement de l'air. Néanmoins, tout fluide caloporteur disposant d'une bonne capacité d'extraction de la chaleur peut être envisagé comme fluide caloporteur 2 traversant l'ailette de refroidissement 12.

La présente invention a donc pour objet de proposer une forme d'ailette de refroidissement 12 permettant un brassage du fluide caloporteur 2 dans le sens du fluide caloporteur pour lequel l'échange thermique est souhaité.

Le but de ce brassage est de permettre au fluide caloporteur entrant dans l'échangeur dans une zone éloignée de la surface d'échange thermique 10, de se retrouver, à un niveau quelconque de l'échangeur dans le sens de l'écoulement dudit fluide caloporteur, au niveau d'une zone proche de cette surface d'échange thermique 10.

Ce même brassage amène, de manière réciproque, le fluide caloporteur entrant dans l'échangeur dans une zone proche de la surface d'échange thermique, à passer dans une zone éloignée de cette même surface d'échange thermique le long de la surface thermique dans le sens du flux d'écoulement de ce fluide.

Cette notion de brasage du fluide entrant permet de faire évoluer le gradient thermique entre le fluide entrant dans l'échangeur et les parties conductrices servant audit échange.

Le but de la forme est de permettre une régénération d'un fluide caloporteur 2 tel que de l'air n'ayant pas été en contact avec la surface d'échange thermique 10 à l'entrée de l'échangeur selon la première direction D1 pour lui permettre de l'être plus loin le long de la première direction D1 dans ledit échangeur dans sa trajectoire à travers l'échangeur thermique.

La forme définie par une double courbure guide permet un brassage efficace tout en limitant les pertes de charges pouvant être induites par des formes trop abruptes.

Le but est d'optimiser les échanges thermiques par une augmentation du gradient thermique le long du flux du fluide dans l'échangeur thermique, ceci par le fait que la température du fluide en contact avec la surface d'échange varie le long du flux, réduisant son gradient avec le 2ième élément thermique, le fait d'avoir une forme permettant un brassage du flux ramène du fluide n'ayant pas eu, ou à moindre mesure, d'échange thermique avec la surface d'échange thermique vers la surface d'échange thermique en vue d'augmenter le gradient de température, et donc l'efficacité d'échange thermique.

L'ailette de refroidissement 12 peut être continue ou discontinue par endroit, présenter des orifices de communication et/ou des formes saillants pouvant servir à modifier l'écoulement du fluide et générer un brassage voire une inversion de la position du fluide caloporteur par rapport à la surface d'échange thermique 10.

Ce type de guide de brassage de fluide 14 et d'interface d'inversion 15 de fluide est avantageusement réalisé par un procédé de fabrication d'impression 3D métallique fonctionnant par addition de matière. En variante, un procédé de fabrication d'impression 3D quelconque fonctionnant par addition de matière peut être envisagé.

**Revendications**

1. Dispositif de refroidissement (1) présentant une surface d'échange thermique (10) configuré pour permettre un échange thermique avec un fluide caloporteur (2) le long de la surface d'échange thermique selon une première direction (D1), l'échange thermique s'opérant par convection entre la surface d'échange thermique (10) et le fluide caloporteur (2), le dispositif de refroidissement (1) comprenant au moins une ailette de refroidissement (12), la surface d'échange thermique (10) étant configurée pour recevoir par conduction de la chaleur destinée à être évacuée par l'ailette de refroidissement (12), l'ailette de refroidissement (12) comprenant au moins un guide de brassage de fluide (14) fixe et à distance par rapport à la surface d'échange thermique (10), l'au moins un guide de brassage du fluide (14) étant disposé de sorte à générer une redirection du fluide caloporteur (2) selon une deuxième direction (D2) sécante de la première direction (D1), le dispositif de refroidissement étant **caractérisé en ce que** l'au moins un guide de brassage de fluide (14) présente une surface gauche.

2. Dispositif de refroidissement (1) selon la revendication 1, dans lequel la deuxième direction (D2) est orientée en direction de la surface d'échange thermique (10), la deuxième direction (D2) ayant une composante sensiblement perpendiculaire à la surface d'échange thermique (10).

3. Dispositif de refroidissement (1) selon la revendication 2, dans lequel l'au moins un guide de brassage (14) étant disposé de sorte à générer une redirection du fluide caloporteur (2) selon une troisième direction (D3) sécante de la première direction (D1) et de la deuxième direction (D2), la troisième direction (D3) ayant la même origine que la deuxième direction (D2) selon un premier plan (P1) perpendiculaire à la surface d'échange thermique (10), la troisième direction (D3) ayant une composante sensiblement perpendiculaire à la surface d'échange thermique (10) opposée à la composante sensiblement perpendiculaire à la surface d'échange thermique (10) de la deuxième direction (D2) selon le premier plan (P1).

4. Dispositif de refroidissement (1) selon la revendication 3, dans lequel l'ailette de refroidissement comprend :

   - une première paroi (120) s'étendant selon un deuxième plan (P2) sensiblement parallèle à la première direction (D1) et parallèle au premier plan (P1), la première paroi étant configurée pour recevoir par conduction de la chaleur destinée à être évacuée par l'ailette de refroidissement (12), l'au moins un guide de brassage (14) étant relié à la première paroi (120) par le biais d'un premier support de fixation (120').

5. Dispositif de refroidissement (1) selon la revendication 4, dans lequel l'ailette de refroidissement comprend :

- une deuxième paroi (122) s'étendant selon un troisième plan (P3) parallèle au premier plan (P1) et distinct du deuxième plan (P2), le guide de brassage (14) étant relié à la deuxième paroi (122) par le biais d'un deuxième support de fixation (122').

6. Dispositif de refroidissement (1) selon la revendication 5, dans lequel le deuxième plan (P2) est parallèle au premier plan (P1) et/ou le troisième plan (P3) est parallèle du premier plan (P1).

7. Dispositif de refroidissement (1) selon la revendication 5 ou 6, dans lequel le fluide caloporteur (2) compris entre la première paroi (120) et la deuxième paroi (122) comprend un premier volume (v1) de fluide caloporteur disposé entre la surface d'échange thermique (10) et une première surface guide (140) de l'au moins un guide de brassage (14) du fluide caloporteur et un deuxième volume (v2) de fluide caloporteur disposé au contact d'une deuxième surface guide (142) de l'au moins un guide de brassage de fluide (14), la première surface guide (140) présentant une forme concave et la deuxième surface guide présentant une forme concave par rapport à un premier segment (S1) sensiblement confondu avec l'au moins un guide de brassage de fluide (14) et parallèle à la première direction (D1).

8. Dispositif de refroidissement (1) selon la revendication 7, dans lequel l'au moins un guide de brassage de fluide (14) comprend une interface d'inversion (15) du fluide caloporteur configuré pour rediriger le fluide caloporteur (2) compris dans le deuxième volume (v2) de fluide caloporteur en direction du premier volume (v1) de fluide caloporteur.

9. Dispositif de refroidissement (1) selon la revendication 8, dans lequel l'interface d'inversion (15) du fluide caloporteur configuré pour rediriger le fluide caloporteur (2) compris dans le premier volume (v1) de fluide caloporteur en direction du deuxième volume (v2) de fluide caloporteur.

10. Dispositif de refroidissement (1) selon l'une des revendications 8 ou 9, dans lequel l'interface d'inversion (15) du fluide caloporteur comprend une première zone d'inversion (150) de flux reliée à la première paroi (120) et/ou la deuxième paroi (122) et une deuxième zone d'inversion (152) du flux reliée à la première paroi (120) et/ou la deuxième paroi (122), la première surface guide (140) dans la première zone d'inversion (150) étant de forme concave par rapport à la zone d'échange thermique (10) et la deuxième surface guide (142) dans la deuxième zone d'inversion (152) étant de forme convexe par rapport à la surface d'échange thermique (10).

11. Dispositif de refroidissement (1) selon la revendication 10, dans lequel la première surface guide (140) dans la première zone d'inversion (150) est de forme concave entre deux bornes du premier segment (S1) et la deuxième surface guide (142) dans la deuxième zone d'inversion (152) est de forme concave entre les deux bornes du premier segment (S1).

12. Dispositif de refroidissement (1) selon l'une des revendications 10 à 11, dans lequel la première zone d'inversion (150) est apte à induire une première rotation du fluide caloporteur (2) du premier volume (v1) de fluide caloporteur et dans lequel la deuxième zone d'inversion (152) est apte à induire une deuxième rotation du fluide caloporteur du deuxième volume (v2) de fluide caloporteur (2) selon un axe de rotation parallèle à la première direction (D1).

13. Dispositif de refroidissement selon l'une des revendications 5 à 12, dans lequel l'au moins un guide de brassage (14) comprend guide additionnel s'étendant perpendiculairement à la première paroi (120) et à la deuxième paroi (122), le guide additionnel comprenant une première surface de guidage additionnelle en regard de la première paroi et une deuxième surface de guidage additionnelle en regard de la deuxième paroi, la première surface guidage additionnelle et la deuxième surface de guidage additionnelle présentant une forme convexe selon un deuxième segment sensiblement confondu avec le guide additionnel et parallèle à la première direction (D1).

14. Dispositif de refroidissement selon la revendication 10, dans lequel la première surface guide (140) dans la première zone d'inversion (150) et la deuxième surface guide (142) dans la deuxième zone d'inversion (152) sont définies selon l'équation mathématique suivante :

$$D = f_1(X) \cdot \sin\big(f_2(X)\big)$$

dans laquelle $D$ représente le déplacement du fluide caloporteur par rapport à la première direction (D1) entre une entrée de l'interface d'inversion et une sortie de l'interface d'inversion selon la première direction (D1), $X$ représente une position du fluide caloporteur le long de la première direction (D1) entre l'entrée de l'interface d'inversion et la sortie de l'interface d'inversion, $X$ étant défini à 0 arbitrairement à l'entrée dans l'interface d'inversion, $f_x$ représentent

des fonctions mathématiques quelconques.

15. Dispositif de refroidissement selon la revendication 10, dans lequel la première surface guide (140) dans la première zone d'inversion (150) et la deuxième surface guide (142) dans la deuxième zone d'inversion (152) sont définies selon l'équation mathématique suivante :

$$D = \sum_0^n \alpha_n \cdot X^n$$

dans lequel $D$ représente le déplacement du fluide caloporteur par rapport à la première direction (D1) entre une entrée de l'interface d'inversion et une sortie de l'interface d'inversion selon la première direction (D1), $X$ représente une position du fluide caloporteur le long de la première direction (D1) entre l'entrée de l'interface d'inversion et la sortie de l'interface d'inversion, $X$ étant défini à 0 arbitrairement à l'entrée dans l'interface d'inversion, $\alpha_n$ représente un paramètre type coefficient réel.

**Patentansprüche**

1. Kühlvorrichtung (1), die eine Wärmeaustauschoberfläche (10) aufweist, die dazu konfiguriert ist, einen Wärmeaustausch mit einem Wärmeträgerfluid (2) entlang der Wärmeaustauschoberfläche in einer ersten Richtung (D1) zu ermöglichen, wobei der Wärmeaustausch durch Konvektion zwischen der Wärmeaustauschoberfläche (10) und dem Wärmeträgerfluid (2) erfolgt, wobei die Kühlvorrichtung (1) mindestens eine Kühlrippe (12) umfasst, wobei die Wärmeaustauschoberfläche (10) dazu konfiguriert ist, durch Wärmeleitung Wärme aufzunehmen, die über die Kühlrippe (12) abgeführt werden soll, wobei die Kühlrippe (12) mindestens eine feste und von der Wärmeaustauschoberfläche (10) beabstandete Fluidumwälzführung (14) umfasst,
wobei die mindestens eine Fluidumwälzführung (14) so angeordnet ist, dass sie eine Umlenkung des Wärmeträgerfluids (2) in eine zweite Richtung (D2) erzeugt, die die erste Richtung (D1) schneidet, wobei die Kühlvorrichtung **dadurch gekennzeichnet ist, dass** die mindestens eine Fluidumwälzführung (14) eine linke Oberfläche aufweist.

2. Kühlvorrichtung (1) nach Anspruch 1, wobei die zweite Richtung (D2) in Richtung der Wärmeaustauschoberfläche (10) ausgerichtet ist, wobei die zweite Richtung (D2) eine Komponente aufweist, die im Wesentlichen senkrecht zur Wärmeaustauschoberfläche (10) verläuft.

3. Kühlvorrichtung (1) nach Anspruch 2, wobei die mindestens eine Umwälzführung (14) so angeordnet ist, dass sie eine Umlenkung des Wärmeträgerfluids (2) in eine dritte Richtung (D3) erzeugt, die die erste Richtung (D1) und die zweite Richtung (D2) schneidet, wobei die dritte Richtung (D3) denselben Ursprung wie die zweite Richtung (D2) in einer ersten Ebene (P1) senkrecht zur Wärmeaustauschoberfläche (10) aufweist, wobei die dritte Richtung (D3) eine zur Wärmeaustauschoberfläche (10) im Wesentlichen senkrechte Komponente aufweist, die der zur Wärmeaustauschoberfläche (10) im Wesentlichen senkrechten Komponente der zweiten Richtung (D2) in der ersten Ebene (P1) entgegengesetzt ist.

4. Kühlvorrichtung (1) nach Anspruch 3, wobei die Kühlrippe umfasst:

   - eine erste Wand (120), die sich in einer zweiten Ebene (P2) im Wesentlichen parallel zur ersten Richtung (D1) und parallel zur ersten Ebene (P1) erstreckt, wobei die erste Wand dazu konfiguriert ist, durch Wärmeleitung Wärme aufzunehmen, die über die Kühlrippe (12) abgeführt werden soll, wobei die mindestens eine Umwälzführung (14) mittels einer ersten Befestigungshalterung (120') mit der ersten Wand (120) verbunden ist.

5. Kühlvorrichtung (1) nach Anspruch 4, wobei die Kühlrippe umfasst:

   - eine zweite Wand (122), die sich in einer dritten Ebene (P3) parallel zur ersten Ebene (P1) und getrennt von der zweiten Ebene (P2) erstreckt, wobei die Umwälzführung (14) mittels einer zweiten Befestigungshalterung (122') mit der zweiten Wand (122) verbunden ist.

6. Kühlvorrichtung (1) nach Anspruch 5, wobei die zweite Ebene (P2) parallel zur ersten Ebene (P1) liegt und/oder die dritte Ebene (P3) parallel zur ersten Ebene (P1) liegt.

7. Kühlvorrichtung (1) nach Anspruch 5 oder 6, wobei das zwischen der ersten Wand (120) und der zweiten Wand (122) enthaltene Wärmeträgerfluid (2) ein erstes Volumen (v1) des Wärmeträgerfluids, das zwischen der Wärmeaustauschoberfläche (10) und einer ersten Führungsoberfläche (140) der mindestens einen Fluidumwälzführung (14) des Wärmeträgermediums angeordnet ist, und ein zweites Volumen (v2) des Wärmeträgerfluids umfasst, das in Kontakt mit einer zweiten Führungsoberfläche (142) der mindestens einen Fluidumwälzführung (14) angeordnet ist, wobei die erste Führungsoberfläche (140) eine konkave Form aufweist und die zweite Führungsoberfläche eine konkave Form in Bezug auf ein erstes Segment (S1) aufweist, das im Wesentlichen mit der mindestens einen Fluidumwälzführung (14) zusammenfällt und parallel zur ersten Richtung (D1) verläuft.

8. Kühlvorrichtung (1) nach Anspruch 7, wobei die mindestens eine Fluidumwälzführung (14) eine Umkehrschnittstelle (15) des Wärmeträgerfluids umfasst, die dazu konfiguriert ist, das im zweiten Volumen (v2) des Wärmeträgerfluids enthaltene Wärmeträgerfluid (2) in Richtung des ersten Volumens (v1) des Wärmeträgerfluids umzuleiten.

9. Kühlvorrichtung (1) nach Anspruch 8, wobei die Umkehrschnittstelle (15) des Wärmeträgerfluids dazu konfiguriert ist, das im ersten Volumen (v1) des Wärmeträgerfluids enthaltene Wärmeträgerfluid (2) in Richtung des zweiten Volumens (v2) des Wärmeträgerfluids umzuleiten.

10. Kühlvorrichtung (1) nach einem der Ansprüche 8 oder 9, wobei die Umkehrschnittstelle (15) des Wärmeträgerfluids eine erste Strömungsumkehrzone (150) umfasst, die mit der ersten Wand (120) und/oder der zweiten Wand (122) verbunden ist, und eine zweite Strömungsumkehrzone (152), die mit der ersten Wand (120) und/oder der zweiten Wand (122) verbunden ist, wobei die erste Führungsoberfläche (140) in der ersten Umkehrzone (150) in Bezug auf die Wärmeaustauschoberfläche (10) konkav geformt ist und die zweite Führungsoberfläche (142) in der zweiten Umkehrzone (152) in Bezug auf die Wärmeaustauschzone (10) konvex geformt ist.

11. Kühlvorrichtung (1) nach Anspruch 10, wobei die erste Führungsoberfläche (140) in der ersten Umkehrzone (150) zwischen zwei Grenzen des ersten Segments (S1) konkav geformt ist und die zweite Führungsoberfläche (142) in der zweiten Umkehrzone (152) zwischen den beiden Grenzen des ersten Segments (S1) konkav geformt ist.

12. Kühlvorrichtung (1) nach einem der Ansprüche 10 bis 11, wobei die erste Umkehrzone (150) geeignet ist, eine erste Rotation des Wärmeträgerfluids (2) des ersten Volumens (v1) des Wärmeträgerfluids zu induzieren, und wobei die zweite Umkehrzone (152) geeignet ist, eine zweite Rotation des Wärmeträgers des zweiten Volumens (v2) des Wärmeträgerfluids (2) entlang einer zur ersten Richtung (D1) parallelen Rotationsachse zu induzieren.

13. Kühlvorrichtung nach einem der Ansprüche 5 bis 12, wobei die mindestens eine Umwälzführung (14) eine zusätzliche Führung umfasst, die sich senkrecht zur ersten Wand (120) und zur zweiten Wand (122) erstreckt, wobei die zusätzliche Führung eine erste zusätzliche Führungsoberfläche gegenüber der ersten Wand und eine zweite zusätzliche Führungsoberfläche gegenüber der zweiten Wand umfasst, wobei die erste zusätzliche Führungsoberfläche und die zweite zusätzliche Führungsoberfläche eine konvexe Form entlang eines zweiten Segments aufweisen, das im Wesentlichen mit der zusätzlichen Führung zusammenfällt und parallel zur ersten Richtung (D1) verläuft.

14. Kühlvorrichtung nach Anspruch 10, wobei die erste Führungsoberfläche (140) in der ersten Umkehrzone (150) und die zweite Führungsoberfläche (142) in der zweiten Umkehrzone (152) durch die folgende mathematische Gleichung definiert sind:

$$D = f_1(X) \cdot \sin\left(f_2(X)\right)$$

wobei $D$ die Verschiebung des Wärmeträgerfluids in Bezug auf die erste Richtung (D1) zwischen einem Einlass der Umkehrschnittstelle und einem Auslass der Umkehrschnittstelle entlang der ersten Richtung (D1) darstellt, $X$ eine Position des Wärmeträgerfluids entlang der ersten Richtung (D1) zwischen dem Einlass der Umkehrschnittstelle und dem Auslass der Umkehrschnittstelle darstellt, wobei $X$ am Einlass in die Umkehrschnittstelle willkürlich auf 0 gesetzt wird, $f_x$ beliebige mathematische Funktionen darstellen.

15. Kühlvorrichtung nach Anspruch 10, wobei die erste Führungsoberfläche (140) in der ersten Umkehrzone (150) und die zweite Führungsoberfläche (142) in der zweiten Umkehrzone (152) durch die folgende mathematische Gleichung definiert sind:

$$D = \sum_{0}^{n} \alpha_n \cdot X^n$$

wobei *D* die Verschiebung des Wärmeträgerfluids in Bezug auf die erste Richtung (D1) zwischen einem Einlass der Umkehrschnittstelle und einem Auslass der Umkehrschnittstelle entlang der ersten Richtung (D1) darstellt, *X* eine Position des Wärmeträgerfluids entlang der ersten Richtung (D1) zwischen dem Einlass der Umkehrschnittstelle und dem Auslass der Umkehrschnittstelle darstellt, wobei X am Einlass in die Umkehrschnittstelle willkürlich auf 0 gesetzt wird, $\alpha_n$ einen Parameter vom Typ eines realen Koeffizienten darstellt.

**Claims**

1. A cooling device (1) having a heat exchange surface (10) configured to allow a heat exchange with a heat transfer fluid (2) along the heat exchange surface in a first direction (D1), wherein the heat exchange occurs by convection between the heat exchange surface (10) and the heat transfer fluid (2), the cooling device (1) comprising at least one cooling fin (12), the heat exchange surface (10) being configured to receive, by conduction, heat intended to be dissipated by the cooling fin (12), the cooling fin (12) comprising at least one fluid mixing guide (14) fixed and spaced apart from the heat exchange surface (10),

   the at least one fluid mixing guide (14) being disposed so as to generate a redirection of the heat-transfer fluid (2) in a second direction (D2) intersecting the first direction (D1), the cooling device being **characterized in that** the at least one fluid mixing guide (14) has a left surface.

2. The cooling device (1) according to claim 1, wherein the second direction (D2) is oriented toward the heat exchange surface (10), the second direction (D2) having a component substantially perpendicular to the heat exchange surface (10).

3. The cooling device (1) according to claim 2, wherein the at least one mixing guide (14) is disposed such that it generates a redirection of the heat transfer fluid (2) in a third direction (D3) intersecting the first direction (D1) and the second direction (D2), the third direction (D3) having the same origin as the second direction (D2) along a first plane (P1) perpendicular to the heat exchange surface (10), the third direction (D3) having a component substantially perpendicular to the heat exchange surface (10) opposite to the component substantially perpendicular to the heat exchange surface (10) of the second direction (D2) along the first plane (P1).

4. The cooling device (1) according to claim 3, wherein the cooling fin comprises:

   - a first wall (120) extending along a second plane (P2) substantially parallel to the first direction (D1) and parallel to the first plane (P1), the first wall being configured to receive, by conduction, heat intended to be dissipated by the cooling fin (12), the at least one mixing guide (14) being linked to the first wall (120) via a first mounting bracket (120').

5. The cooling device (1) according to claim 4, wherein the cooling fin comprises:

   - a second wall (122) extending along a third plane (P3) parallel to the first plane (P1) and distinct from the second plane (P2), the mixing guide (14) being linked to the second wall (122) via a second mounting bracket (122').

6. The cooling device (1) according to claim 5, wherein the second plane (P2) is parallel to the first plane (P1) and/or the third plane (P3) is parallel to the first plane (P1).

7. The cooling device (1) according to claim 5 or 6, wherein the heat transfer fluid (2) comprised between the first wall (120) and the second wall (122) comprises a first volume (v1) of heat transfer fluid disposed between the heat exchange surface (10) and a first guide surface (140) of the at least one heat transfer fluid mixing guide (14) and a second volume (v2) of heat transfer fluid disposed in contact with a second guide surface (142) of the at least one heat transfer fluid mixing guide (14), the first guide surface (140) having a concave shape and the second guide surface having a concave shape with respect to a first segment (S1) substantially coincident with the at least one fluid mixing guide (14) and parallel to the first direction (D1).

8. The cooling device (1) according to claim 7, wherein the at least one fluid mixing guide (14) comprises a reversal interface (15) of the heat transfer fluid configured to redirect the heat transfer fluid (2) comprised in the second heat transfer fluid volume (v2) in the direction of the first heat transfer fluid volume (v1).

9. The cooling device (1) according to claim 8, wherein the reversal interface (15) of the heat transfer fluid is configured to redirect the heat transfer fluid (2) comprised in the first heat transfer fluid volume (v1) in the direction of the second heat transfer fluid volume (v2).

10. The cooling device (1) according to one of claims 8 or 9, wherein the reversal interface (15) of the heat transfer fluid comprises a first flow reversal zone (150) linked to the first wall (120) and/or the second wall (122) and a second flow reversal zone (152) linked to the first wall (120) and/or the second wall (122), the first guide surface (140) in the first flow reversal zone (150) being concave relative to the heat exchange surface (10) and the second guide surface (142) in the second flow reversal zone (152) being convex relative to the heat exchange surface (10).

11. The cooling device (1) according to claim 10, wherein the first guide surface (140) in the first reversal zone (150) is concave between two endpoints of the first segment (S1), and the second guide surface (142) in the second reversal zone (152) is concave between the two endpoints of the first segment (S1).

12. The cooling device (1) according to one of claims 10 to 11, wherein the first reversal zone (150) is able to induce a first rotation of the heat transfer fluid (2) of the first volume (v1) of heat transfer fluid, and wherein the second reversal zone (152) is able to induce a second rotation of the heat transfer fluid of the second volume (v2) of heat transfer fluid (2) along an axis of rotation parallel to the first direction (D1).

13. The cooling device according to any one of claims 5 to 12, wherein the at least one mixing guide (14) comprises an additional guide extending perpendicularly to the first wall (120) and to the second wall (122), the additional guide comprising a first additional guide surface facing the first wall and a second additional guide surface facing the second wall, the first additional guide surface and the second additional guide surface having a convex shape along a second segment substantially coincident with the additional guide and parallel to the first direction (D1).

14. The cooling device according to claim 10, wherein the first guide surface (140) in the first reversal zone (150) and the second guide surface (142) in the second reversal zone (152) are defined by the following mathematical equation:

$$D = f_1(X) \cdot \sin\left(f_2(X)\right)$$

wherein $D$ represents the displacement of the heat transfer fluid relative to the first direction (D1) between an inlet of the reversal interface and an outlet of the reversal interface along the first direction (D1), $X$ represents a position of the heat transfer fluid along the first direction (D1) between the inlet of the inversion interface and the outlet of the inversion interface, with $X$ arbitrarily set to 0 at the inlet to the inversion interface, and $f_x$ represent arbitrary mathematical functions.

15. The cooling device according to claim 10, wherein the first guide surface (140) in the first reversal zone (150) and the second guide surface (142) in the second reversal zone (152) are defined by the following mathematical equation:

$$D = \sum_0^n \alpha_n \cdot X^n$$

wherein $D$ represents the displacement of the heat transfer fluid relative to the first direction (D1) between an inlet of the reversal interface and an outlet of the reversal interface along the first direction (D1), $X$ represents a position of the heat transfer fluid along the first direction (D1) between the inlet of the inversion interface and the outlet of the inversion interface, with $X$ arbitrarily set to 0 at the inlet to the inversion interface, and $\alpha_n$ represents a real coefficient type parameter.

FIG.1

FIG.2

FIG.3

FIG.4

FIG.5

FIG.6

FIG.7

FIG.8

**FIG.9**

**FIG.10**

FIG.11

FIG.12

FIG.13

FIG.14

FIG.15

## EP 4 643 077 B1

**Documents brevets cités dans la description**

- DE 202004020294 U